# EUROPÄISCHE PATENTSCHRIFT

(11) **EP 1 445 795 B1**
(45) Veröffentlichungstag und Bekanntmachung des Hinweises auf die Patenterteilung: **27.04.2011**
(21) Anmeldenummer: 04001264.3
(22) Anmeldetag: 21.01.2004
(51) Int. Cl.: H05K 1/16, H01L 21/02

(54) **Verfahren zum Herstellen von Schaltungsträgern mit integrierten passiven Bauelementen**
Methof of manufacturing circuit carriers with integrated passive circuit elements
Procédé de fabrication de supports de circuits électriques comportant des composants électroniques passifs intégrés

(30) Priorität: 21.01.2003 DE 10302104
(43) Veröffentlichungstag der Anmeldung: 11.08.2004
(73) Patentinhaber: FRIWO Gerätebau GmbH, 48346 Ostbevern (DE)
(72) Erfinder: Bothe, Michael, 48346 Ostbevern (DE); Mörbe, Stefan, 49205 Hasbergen (DE)
(74) Vertreter: Grünecker, Kinkeldey, Stockmair & Schwanhäusser Anwaltssozietät

(56) Entgegenhaltungen:
- US-A- 4 508 754
- US-A- 5 814 366
- US-A1- 2001 001 406

## Beschreibung

Die vorliegende Erfindung bezieht sich auf ein Verfahren zum Herstellen einer elektrischen Baugruppe mit einem Schaltungsträger und mindestens einem in dem Schaltungsträger integrierten passiven Bauelement, das ein elektrisch funktionales Material aufweist.

In einer Vielzahl von elektronischen Geräten werden heute passive Bauelemente, wie Widerstände und Kondensatoren oder aber Induktivitäten, auf möglichst engem Raum benötigt. Kondensatoren werden beispielsweise für die Unterdrückung von Störungen, für die Filterung von Signalen sowie für die Energiespeicherung eingesetzt. Dabei kommen zur Herstellung unterschiedliche Technologien in Frage. Während für Kondensatoren mit hohen Kapazitäten auch heute noch aus Preisgründen gewickelte Elektrolytkondensatoren verwendet werden, setzt man in Siebanwendungen neben Tantalkondensatoren auch zunehmend Keramikkondensatoren ein.

Diese Bauelemente haben den Vorteil, dass sie zum einen verbesserte Hochfrequenzeigenschaften haben und zum anderen einen kleinen Ersatzserienwiderstand auch bei hoher Strombelastbarkeit aufweisen. Um eine ausreichende Kapazität bei kleiner Fläche zu erreichen, werden diese Kondensatoren vielfach in Mehrlagentechnik (MLC) hergestellt. Dieses Verfahren ist jedoch sehr aufwändig und führt zu hohen Kosten.

In netzbetriebenen Stromversorgungen werden Kondensatoren zur Siebung und Filterung der Netzeingangsspannung, der auf die Sekundärseite übertragenen Kleinspannung sowie zur Störunterdrückung an integrierten Schaltungen eingesetzt. Insbesondere Keramikkondensatoren sind in diesem Zusammenhang von Vorteil.

Mit Hilfe der Dickschichttechnologie sind derartige Schaltungsaufbauten auf einem Keramiksubstrat verwirklicht, bei denen Leiterbahnen und Widerstände integriert sind. Als Keramiksubstrat wird Aluminiumoxid verwendet, was den Vorteil einer guten Wärmeleitfähigkeit und einer hohen Isolationsfestigkeit bietet. Aufgrund der geringen Dielektrizitätszahl dieses Materials (εᵣ ungefähr gleich 9) ist jedoch nur eine sehr geringe Kapazität pro Fläche (<1 pF/mm²) erreichbar, da der Abstand der Elektroden aufgrund der benötigten mechanischen Stabilität nicht beliebig verringert werden kann. Eine sinnvolle Integration von Kapazitäten in der Größenordnung von 1 nF bis 100 µF ist damit nicht erreichbar.

Eine weitere bekannte Möglichkeit zur Herstellung derartiger Keramikkondensatoren besteht in der Ausbildung durch eine Monolayerstruktur, bei der nur eine einzige Schicht dielektrisches Material verwendet wird. Dadurch ergibt sich eine einfache Herstellungsweise. Da außerdem die Metallisierung im Anschluss an das Brennen erfolgen kann, können Materialien mit hohen Brenntemperaturen und damit hohen Dielektrizitätszahlen εᵣ > 5000 verwendet werden. Da die Paneldicke aus Gründen der mechanischen Stabilität mindestens 0,2 mm sein muss, ergibt sich eine hohe Spannungsfestigkeit. Dennoch reicht diese Stabilität in der Regel nicht aus, um größere Flächen und damit größere Kapazitätswerte zu realisieren. Aufgrund der Monoschichtstruktur ergibt sich jedoch wiederum nur eine geringe Kapazität pro Fläche (0,1 bis 0,2 nF/mm²).

Eine weitere Realisierungsmöglichkeit sind sogenannte Multilagenbauelemente, bei denen viele Lagen (bis zu 300) von dielektrischem Material gestapelt und gesintert werden. Zwischen den einzelnen Lagen befinden sich Elektroden. Mit diesem Verfahren sind hohe Kapazitätswerte erreichbar, wobei die Spannungsfestigkeit über den Abstand der einzelnen Lagen zueinander eingestellt werden kann. Bei höherer Spannungsfestigkeit ergibt sich bei gleicher Baugröße eine geringere Kapazität, da die Lagen dicker werden. Die Herstellung solcher Kondensatoren ist jedoch wegen der Multilayerstruktur aufwändig. Um kostengünstige Materialien für die inneren Elektroden verwenden zu können, muss außerdem die Brenntemperatur gering (d.h. unter 1000°C) gehalten werden. Dies wiederum verhindert den Einsatz von Materialien mit extrem hoher Dielektrizitätszahl (εᵣ > 5000).

Um eine größtmögliche Miniaturisierung z.B. bei der Anwendung in netzbetriebenen Stromversorgungen zu erreichen, werden derartige Kondensatoren in dem eigentlichen Schaltungsträger integriert aufgebaut. Ein Beispiel für einen in dem Schaltungsträger integrierten Mehrlagenkondensator ist in der US-Patentanmeldung US2001/0008479 A1 gezeigt. Hier wird in einer Aussparung des Schaltungsträgers ein Mehrlagenkondensator ausgebildet, der durch anschließendes Pressen und Sintern mit dem Substrat fest verbunden wird. Dabei wird zunächst auf der untersten Schicht des Substrats ein Mehrschichtkondensator aufgebaut, der von einer strukturierten zweiten Schicht des Substrats umschlossen und von einer Deckschicht abgedeckt wird. Dieses Verfahren hat den Nachteil, dass es vergleichsweise aufwändig ist, da die Strukturierung des Mehrlagenkondensators unabhängig und zusätzlich zur Strukturierung der Substratschichten erfolgen muss.

Die US 5,814,366 befasst sich mit der Herstellung eines keramischen Multilayer-Substrats, bei dem eine Kondensatorschicht in einem nicht ausgehärteten sogenannten Green Sheet ausgebildet wird und dieses Green Sheet mit dem Kondensator zusammen mit einer Vielzahl anderer Green Sheets laminiert und schließlich ausgeheizt wird. Die Außenseiten des Aufbaus werden mit Opferschichten geschützt. Dabei wird nur eine einzelne dielektrische Schicht als die dielektrische Schicht des Kondensators angesprochen.

Die US 4,408,754 offenbart ein Verfahren zum Herstellen von Leitungen und Widerständen mit geringer Strukturbreite für Dickfilmmikroschaltungen. Gemäß dieser Druckschrift wird in das Substrat ein Leiterbahnen- bzw. Widerstandsbahnenmuster in Form von eingravierten Linien eingebracht. Anschließend wird die leitfähige Paste oder Widerstandspaste in diese Vertiefungen eingefüllt und der Überschuss entfernt. Die Aushärtung erfolgt durch ausschließlich thermische Energiezufuhr. Weitere Dickfilmstrukturen können im Anschluss an diese Prozessschritte hinzugefügt werden.

Die US 2001/001406 A1 bezieht sich auf ein Verfahren zum Herstellen von Übertragungsleitungen und vergrabenen passiven Komponenten in ungesinterten Bändern, den sogenannten Green Tapes. Gemäß dieser Entgegenhaltung werden Kanäle oder Öffnungen in das Green Tape eingeprägt und eine Tinte eines leitfähigen Materials oder einer passiven Komponente wird in die eingeprägten Kanäle oder Öffnungen eingefüllt. Durch Ausheizen des Green Tapes wird dieses elektrisch funktionale Material in seinen Endzustand übergeführt. Es ist das Ziel des hier vorgeschlagenen Herstellungsverfahrens, eine möglichst gleichmäßige und reproduzierbare Dicke des vergrabenen Kondensators sicherzustellen.

Daher besteht die Aufgabe der vorliegenden Erfindung darin, ein verbessertes Verfahren zum Herstellen einer elektrischen Baugruppe mit einem Schaltungsträger und einer Vielzahl von in dem Schaltungsträger integrierten passiven Bauelementen anzugeben, das die schnelle und kostengünstige Herstellung einerseits gewährleistet und andererseits eine hohe Flexibilität bei der Wahl der beteiligten elektrisch funktionalen Materialien ermöglicht.

Diese Aufgabe wird durch ein Verfahren mit den Merkmalen des Patentanspruchs 1 gelöst.

Vorteilhafte Weiterbildungen der Erfindung sind in den Unteransprüchen beschrieben.

Der Erfindung liegt die Erkenntnis zugrunde, dass der Herstellungsprozess einer derartigen Baugruppe wesentlich vereinfacht werden kann, wenn Vertiefungen, die in dem Schaltungsträger vorgesehen werden, zur Strukturierung des elektrisch funktionalen Materials in einem Rohzustand, beispielsweise in Form einer nicht ausgehärteten Paste, verwendet wird. Passive Bauelemente, wie Kondensatoren und ohmsche Widerstände, aber auch Induktivitäten, können auf diese Weise in besonders effizienter und flächensparender Weise hergestellt werden. Darüber hinaus können Kondensatoren mit unterschiedlichen Kapazitäten und/oder Widerstände mit verschiedenen Leitfähigkeiten, wie auch diverse Induktivitäten, in einem Arbeitsschritt kostengünstig hergestellt werden.

Gemäß einer vorteilhaften Ausführungsform der vorliegenden Erfindung erfolgt die Energiezufuhr durch Ausüben mechanischen Drucks. Von besonderem Vorteil ist hierbei, dass im Falle einer Verwendung von Keramikschaltungsträgem ein solcher Pressschritt zur Verfestigung des elektrisch funktionalen Materials in einem Arbeitsschritt mit einem Pressschritt zur Verfestigung des Schaltungsträgers erfolgen kann.

Zusätzlich oder alternativ zu einer Umwandlung durch Pressen kann die Energiezufuhr auch durch eine Wärmezufuhr erfolgen. Dabei können einzelne Bestandteile des elektrisch funktionalen Materials im Rohzustand aufschmelzen und eine feste Verbindung zu dem Schaltungsträger oder auch zu elektrisch leitenden Anschlüssen herstellen.

Die vorteilhaften Eigenschaften des erfindungsgemäßen Verfahrens kommen besonders dann zur Geltung, wenn das passive Bauelement ein Kondensator ist. Bei dem elektrisch funktionalen Material handelt es sich dann um ein Dielektrikum, beispielsweise eine Keramik.

Zusätzlich kann es sich bei dem passiven Bauelement auch um einen Widerstand handeln. In diesem Fall wird als elektrisch funktionales Material eine Substanz mit einer genau definierten elektrischen Leitfähigkeit, wie sie beispielsweise aus der Dickschichttechnologie bekannt ist, eingesetzt. Das erfindungsgemäße Herstellungsverfahren bietet in diesem Zusammenhang auch den Vorteil, dass in besonders effizienter Weise verschiedenste Widerstandswerte hergestellt werden können. Auf einem Schaltungsträger können mit dem erfindungsgemäßen Verfahren außerdem eine Vielzahl unterschiedlicher Kondensatoren und Widerstände realisiert werden. Um bei der Herstellung integrierter Widerstände ausreichend enge Toleranzen einhalten zu können, kann außerdem ein Trimmschritt, zum Beispiel Lasertrimmen, vorgesehen werden.

Das elektrisch funktionale Material kann im Rohzustand beispielsweise in Form einer Paste vorliegen. Dann stellt das Rakeln dieser Paste in die entsprechenden Vertiefungen des Schaltungsträgers eine besonders effiziente und gut automatisierbare Lösung dar.

Alternativ kann das elektrisch funktionale Material in seinem Rohzustand auch in die Vertiefungen eingepresst werden. Dabei kann eine besonders lückenlose und gleichmäßige Ausfüllung auch kleinster Strukturen sichergestellt werden.

Um das integrierte passive Bauelement elektrisch zu kontaktieren, kann mindestens eine Leiterbahnstruktur hergestellt werden. Dabei wird dieser Schritt entweder vor dem Einbringen des elektrisch funktionalen Materials im Rohzustand oder danach sowie bei beidseitiger Kontaktierung vor und nach dem Einbringen aufgebracht.

Die benötigten Aussparungen in dem Schaltungsträger können je nach verwendeten Materialien und benötigten geometrischen Strukturen durch eine Vielzahl von formgebenden Verfahren hergestellt werden. In besonders einfacher Weise können diese Aussparungen durch materialabhebende Bearbeitung des vollen Materials des Schaltungsträgers erfolgen. Insbesondere bei Kleinserien, bei denen nur geringe Stückzahlen hergestellt werden sollen, kann dies eine kostengünstige Variante sein. Alternativ können selbstverständlich auch Formpressverfahren, wie sie generell in der Keramiktechnologie bekannt sind, verwendet werden.

Das Strukturieren des Schaltungsträgers kann aber auch durch Ausbilden mindestens einer ersten Schicht, Ausbilden mindestens einer zweiten Schicht, in welcher Öffnungen angeordnet sind, und anschließendes Zusammenfügen der ersten und zweiten Schichten zu einem Schaltungsträger erfolgen. Diese in der Keramiktechnologie ebenfalls weit verbreitete Strukturierungsmethode hat den Vorteil, dass sie ohne anwendungsspezifische Werkzeuge auskommt und weitestgehend automatisierbar ist. Stellt man z.B. die ersten und zweiten Schichten beide aus Keramik her so umfasst der Schritt des Zusammenfügens das Pressen und Brennen der Keramik. Auf diese Weise können in kostengünstiger und einfacher Weise eine Vielzahl von Strukturen hergestellt werden.

Alternativ kann die zweite Schicht aber auch durch eine Metallisierung gebildet sein. Das Strukturieren von Metallisierungen stellt einen in der Leiterplattenfertigung weit verbreiteten und gut beherrschbaren Technologieschritt dar.

Will man die integrierten passiven Bauelemente nach der Herstellung freilegen, so kann das erfindungsgemäße Verfahren als abschließenden Schritt den Schritt des Entfernens zumindest eines Teils der zweiten Schicht umfassen.

Anhand der in den beiliegenden Zeichnungen dargestellten Ausgestaltungen wird die Erfindung im Folgenden näher erläutert. Ähnliche oder korrespondierende Einzelheiten sind in den Figuren mit denselben Bezugszeichen versehen. Es zeigen:
- Fig. 1: eine schematische Schnittdarstellung eines aus zwei Schichten gebildeten Schaltungsträgers;
- Fig. 2: den Schaltungsträger aus Fig. 1 nach Aufbringen einer Metallisierungsschicht;
- Fig. 3: den Schaltungsträger aus Fig. 2 nach dem Zusammenfügen der Schichten durch Aufeinanderstapeln;
- Fig. 4: den Schaltungsträger aus Fig. 3 nach dem Einbringen eines Dielektrikums im Rohzustand;
- Fig. 5: den Schaltungsträger aus Fig. 4 nach dem Einbringen einer weiteren Metallisierungsschicht;
- Fig. 6: das Pressen und Brennen des Schaltungsträgers aus Fig. 5 in schematischer Darstellung;
- Fig. 7: einen Schaltungsträger gemäß einer Ausführungsform der Erfindung;
- Fig. 8: den Schaltungsträger aus Fig. 7 nach dem Stapeln;
- Fig. 9: eine schematische Darstellung des Press- und Brennvorgangs zum Ausbilden eines gesinterten Schaltungsträgers;
- Fig. 10: den Schaltungsträger der Fig. 9 nach Aufbringen einer geschlossenen Metallisierungsschicht;
- Fig. 11: den Schaltungsträger aus Fig. 10 nach dem teilweisen Entfernen der Metallisierungsschicht;
- Fig. 12: den Schaltungsträger aus Fig. 11 nach dem Einbringen eines Dielektrikums;
- Fig. 13: eine schematische Darstellung des Press- und Brennvorgangs des Schaltungsträgers aus Fig. 12;
- Fig. 14: den Schaltungsträger aus Fig. 13 nach dem Aufbringen einer ganzflächigen Metallisierung;
- Fig. 15: eine schematische Darstellung der fertiggestellten Baugruppe nach dem Strukturieren der zweiten Metallisierungsschicht;
- Fig. 16: eine schematische Schnittdarstellung durch eine Keramikgrundplatte mit einer Öffnung für spätere Durchkontaktierungen;
- Fig. 17: die Grundplatte aus Fig. 16 nach dem vollständigen Überziehen mit einer Kupferschicht;
- Fig. 18: die Grundplatte aus Fig. 17 nach dem Aufbringen einer weiteren Kupferschicht;
- Fig. 19: die Struktur aus Fig. 18 nach dem Strukturieren der Metallschicht;
- Fig. 20: die Struktur aus Fig. 19 nach dem Einbringen einer Dielektrikumsvorstufe in die in dem Metall ausgebildeten Aussparungen;
- Fig. 21: eine schematische Darstellung eines Press- und Brennvorgangs zur Verfestigung des Dielektrikums;
- Fig. 22: die Struktur aus Fig. 21 nach dem Aufbringen einer weiteren Kupferschicht;
- Fig. 23: der Schaltungsträger im Endzustand nach dem teilweisen Entfernen der Kupfermetallisierung;
- Fig. 24: eine schematische Schnittdarstellung eines Schaltungsträgers aus Keramik beim Pressen und Brennen;
- Fig. 25: den Schaltungsträger der Fig. 24 nach dem Strukturieren;
- Fig. 26: den strukturierten Schaltungsträger der Fig. 25 nach dem Aufbringen einer ganzflächigen Metallisierung;
- Fig. 27: den Schaltungsträger der Fig. 26 nach dem Strukturieren der Metallisierung;
- Fig. 28: den Schaltungsträger der Fig. 27 nach dem Einbringen des Dielektrikums im Rohzustand;
- Fig. 29: eine schematische Darstellung des Press- und Brennvorgangs zum Verfestigen des Dielektrikums;
- Fig. 30: den Schaltungsträger der Fig. 29 nach dem Aufbringen einer ganzflächigen zweiten Metallisierung;
- Fig. 31: den Schaltungsträger im Endzustand nach dem Strukturieren der zweiten Metallisierungsschicht.

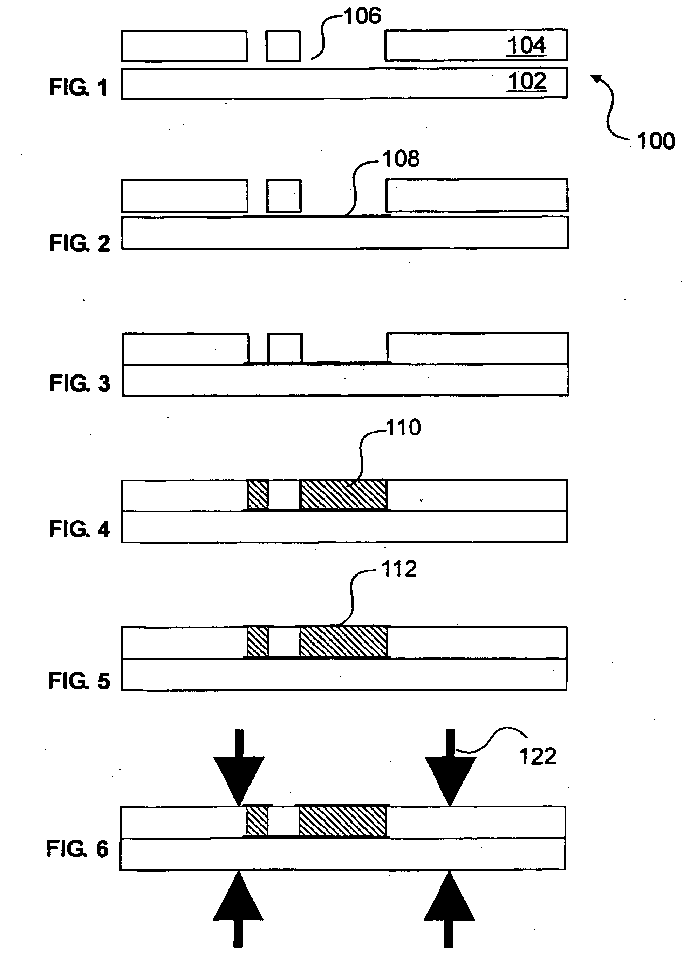

Mit Bezug auf die Fig. 1 bis 6 wird nunmehr ein Herstellungsverfahren näher erläutert.

Bei dem Verfahren wird eine Baugruppe mit unterschiedlichen integrierten Kapazitäten und einem Schaltungsträger aus Keramik hergestellt. Die Keramiksubstrate können eine gute Wärmeableitung gewährleisten. Sie werden derart strukturiert und metallisiert, das Freiräume für einen dielektrischen Stoff im Rohzustand entstehen. Dieser wird in die Freiräume eingebracht und die gestapelten Keramiksubstrate werden gepresst und gesintert. Das Dielektrikum kann von beiden Seiten kontaktiert werden. In Fig. 1 sind eine erste Keramikschicht 102 und zweite Keramikschicht 104 gezeigt, bevor sie aneinandergefügt werden, um einen Schaltungsträger 100 zu bilden. Dabei dient die erste Keramikschicht 102 als Basisschicht und die zweite Keramikschicht 104 wird derart strukturiert, dass Aussparungen 106 für das spätere Einbringen des Dielektrikums entstehen.

Wie aus Fig. 2 ersichtlich, wird zur Kontaktierung der späteren Kondensatoren eine erste Metallisierungsschicht 108 auf der ersten Keramikschicht 102 aufgebracht und strukturiert.

Fig. 3 zeigt den Schaltungsträger 100 nach dem Stapeln der Keramiklagen 102 und 104.

In einem nächsten Schritt (siehe Fig. 4) wird ein Dielektrikum 110 in einem Rohzustand in die Vertiefungen 106 eingebracht. Dies kann beispielsweise mittels Einpressen oder Rakeln einer Paste geschehen.

Wie in Fig. 5 gezeigt, kann zur beidseitigen elektrischen Kontaktierung der späteren Kondensatoren eine zweite Metallisierungsschicht 112 aufgebracht und strukturiert werden. Durch den abschließenden Press- und Brennvorgang, in Fig. 6 durch die Pfeile 122 symbolisiert, werden sowohl die einzelnen Keramikschichten 102, 104 wie auch das Dielektrikum 112 verfestigt und in den Endzustand umgewandelt.

Obwohl in den Fig. 1 bis 6 zwei Kondensatoren als integrierte passive Bauelemente hergestellt werden, kann selbstverständlich eine beliebige Anzahl von passiven Bauelementen in dem Schaltungsträger realisiert werden und es können gleichzeitig oder alternativ zu dem Dielektrikum auch leitfähige Stoffe mit definierter Leitfähigkeit eingebracht werden, um integrierte Widerstände herzustellen. Dabei kann ein Trimmprozess erforderlich sein, um die bei integrierten Widerständen benötigten Toleranzen einzuhalten. Auch die Herstellung integrierter Induktivitäten ist möglich.

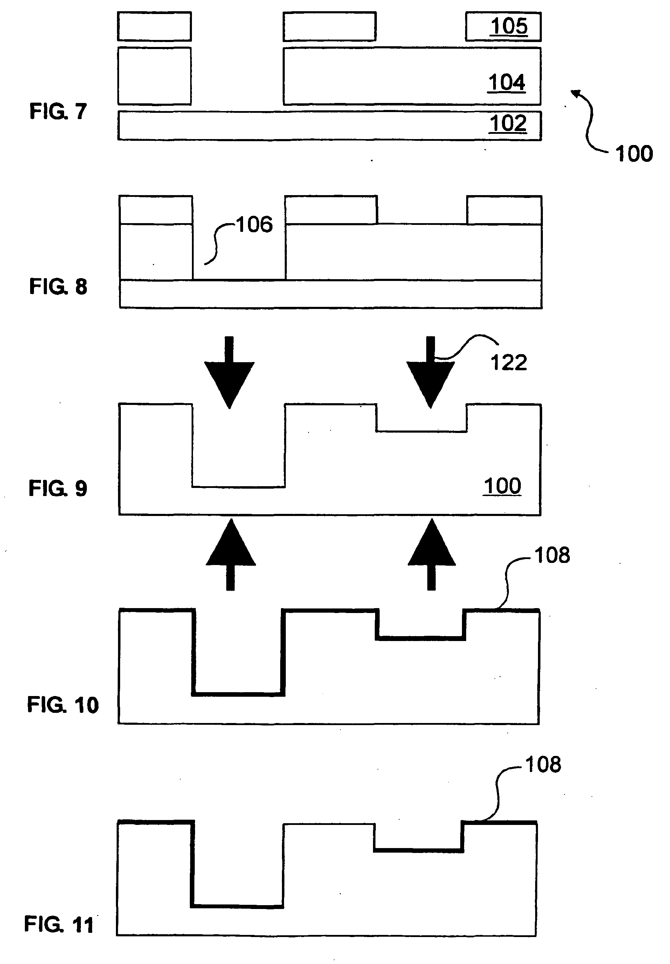

In den Fig. 7 bis 15 wird ein Verfahren gemäß einer Ausführungsform der Erfindung erläutert, mit dessen Hilfe passive Bauelemente unterschiedlicher Dicke hergestellt werden können.

Dabei wird zunächst, wie in Fig. 7 bis 9 gezeigt, ein Keramiksubstrat 100 hergestellt, indem einzelne Keramiklagen 102, 104 und 105 strukturiert, gestapelt und gepresst und gebrannt werden.

Dieses Keramiksubstrat 100 wird auf der strukturierten Seite vollständig metallisiert, die Metallisierung 108 wird durch photostrukturiertes Ätzen oder durch einen dem Damaszenerverfahren ähnlichen Prozess strukturiert (Fig. 10 und 11).

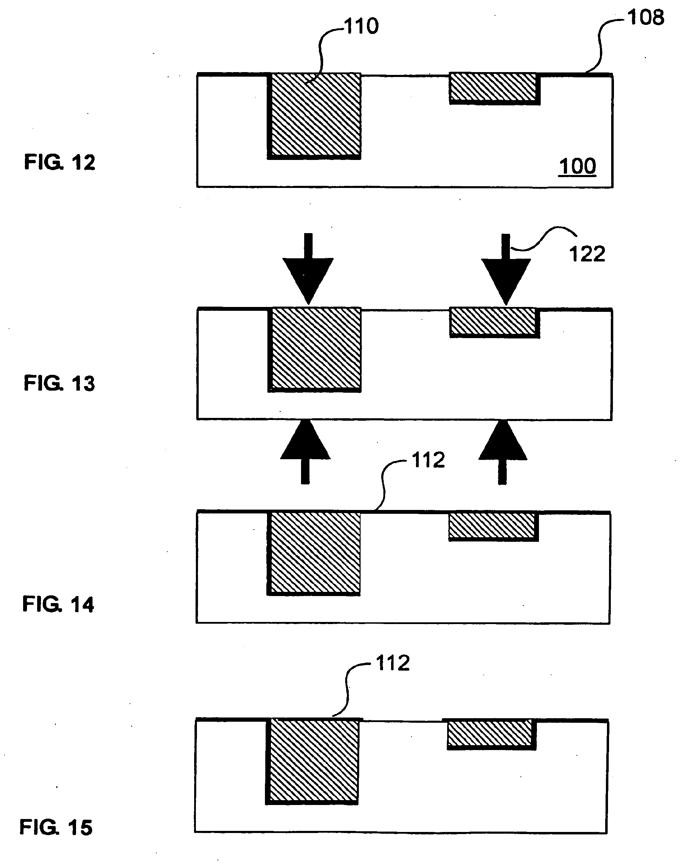

Danach wird das Dielektrikum 112 im Rohzustand in die vorgesehenen Freiräume 106 eingebracht (Fig. 12). Es erfolgt, wie in Fig. 13 symbolisch dargestellt, ein zweiter Brennvorgang. Anschließend werden die noch fehlenden Kontaktflächen durch eine zweite zu strukturierende Metallisierungsschicht 112 hergestellt (Fig. 14 und 15).

Der erste Brennvorgang für das Substrat kann bei hoher Temperatur erfolgen, da hier noch keine Metalle beteiligt sind. Daher kann dieser erste Brennvorgang bezüglich der gewünschten Eigenschaften des Keramiksubstrats optimiert werden. Der zweite Brennprozess für das Dielektrikum 112 kann bei Wahl geeigneter Materialien auch bei niedrigen Temperaturen (unter 1000 °C) stattfinden. In diesem Fall können auch niedriger schmelzende, kostengünstigere Metalle (zum Beispiel Silber) verwendet werden.

Bei dem Verfahren gemäß dieser Ausführungsform können neben den gezeigten Kondensatoren auch Widerstandsbauelemente oder Induktivitäten realisiert werden.

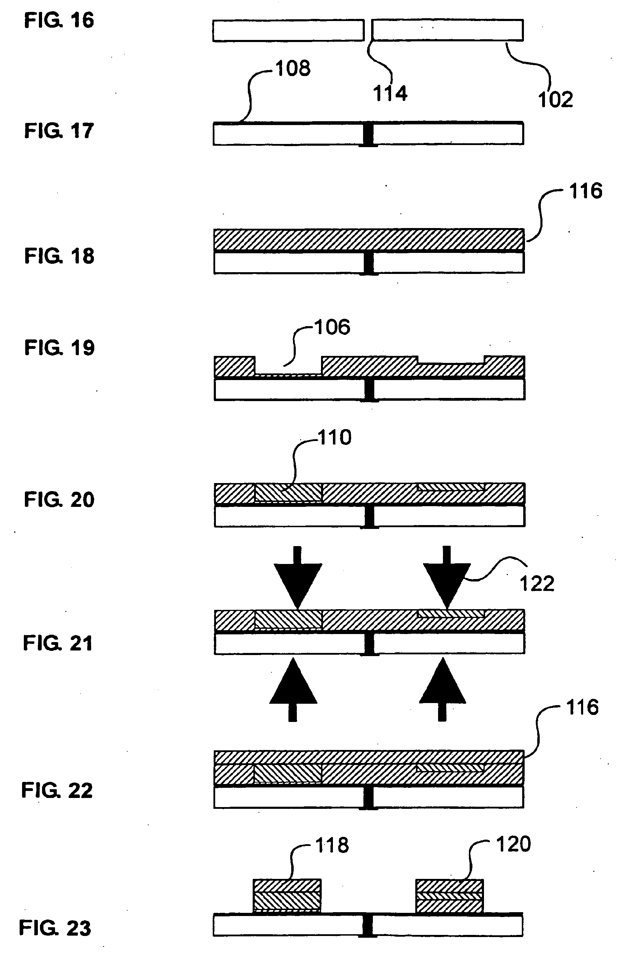

Eine zweite Ausführungsform des erfindungsgemäßen Herstellungsverfahrens soll nun anhand der Fig. 16 bis 23 erläutert werden.

Als Ausgangsstruktur wird eine erste Keramikschicht 102 mit entsprechenden Durchkontaktierungen ("vias") 114 versehen (Fig. 16).

Fig. 17 zeigt den nächsten Schritt, bei dem die erste Keramikschicht 102 vollständig mit einer Kupferschicht 108 überzogen wird. Dabei werden die Durchkontaktierungslöcher 114 ebenfalls metallisiert.

Wie in Fig. 18 dargestellt, wird anschließend eine durchgehende relativ dicke Metallschicht, vorzugsweise eine Kupferschicht 116 aufgebracht. Die Kupferschicht 116 wird beispielsweise durch Ätzen so strukturiert, dass Freiräume 106 für das Dielektrikum entstehen (Fig. 19).

Fig. 20 zeigt die Struktur aus Fig. 19 nach dem Einbringen des Dielektrikums 110. Dieses befindet sich in einem Rohzustand und wird, wie in Fig. 21 angedeutet, durch einen Press- und Brennvorgang in einen Endzustand umgewandelt.

Wie in Fig. 22 dargestellt, wird durch einen nochmaligen Metallisierungsschritt die zweite Kontaktierung der Kondensatoren vorbereitet.

Wie in Fig. 23 skizziert, wird die Metallisierung 116 in einem abschließenden Ätzschritt soweit entfernt, dass die Kondensatoren 118 und 120 voneinander isoliert sind.

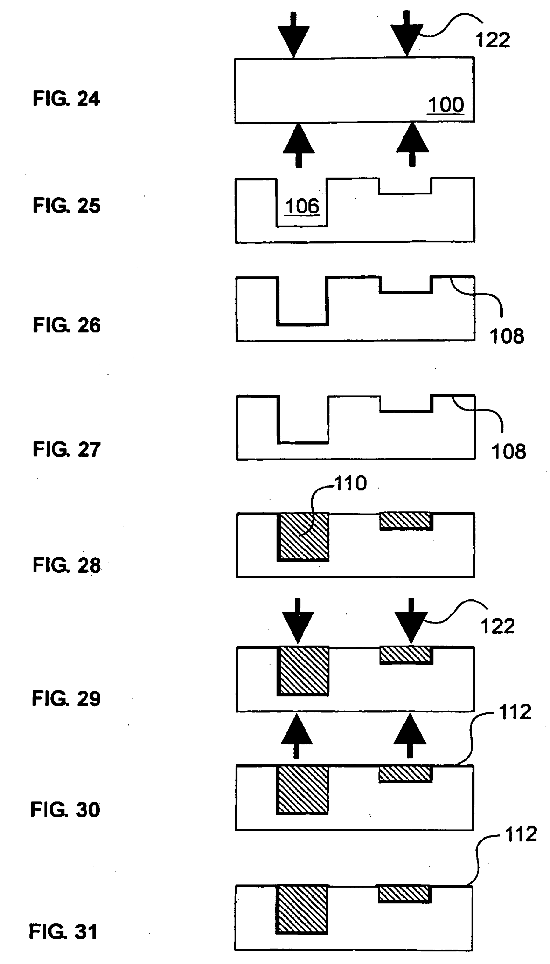

Eine dritte Ausführungsform des erfindungsgemäßen Verfahrens ist in den Fig. 24 bis 31 gezeigt.

Hier erfolgt zunächst ein Press- und Brennvorgang des Keramiksubstrats 100 (Fig. 24). Danach wird, wie in Fig. 25 gezeigt, die Keramik "aus dem Vollen", beispielsweise mittels Fräsen oder einer Laserbearbeitung, strukturiert. Anschließend erfolgen, analog zu den Prozessschritten der Fig. 10 bis 15, die Schritte Metallisierung, Strukturieren der Metallisierung, Einbringen des Dielektrikums sowie ein weiterer Press- und Brennvorgang (Fig. 26 mit 29). Nunmehr müssen die noch fehlenden Kontakte wiederum metallisiert werden. Dies kann entweder mit Hilfe einer Maske durch eine Phototechnik mit zunächst vollständigem Metallisieren und abschließendem Ätzvorgang oder mittels einer Damaszenertechnik erfolgen.

Bei allen gezeigten Ausführungsformen des erfindungsgemäßen Herstellungsprozesses kann für die erste Metallisierung 108 und/oder für die zweite Metallisierung 112 Silberpalladium oder ein anderer Leitwerkstoff mit einer Schmelztemperatur von mehr als 1300 °C verwendet werden. Das Dielektrikum sollte in seinem Endzustand eine vergleichsweise hohe Dielektrizitätszahl aufweisen. So ist beispielsweise für netzbetriebene Stromversorgungen ein Kapazitätsbereich von ca. 1 nF bis 1000 nF mit einer Spannungsfestigkeit von 400 V sowie ein Kapazitätsbereich von 10 nF bis 100 µF mit einer Spannungsfestigkeit von 10 V wünschenswert.

Findet der Brennvorgang in zwei Stufen statt, kann die erste Stufe mit hoher Temperatur erfolgen, wenn keine Metalle mit zu niedrigem Schmelzpunkt beteiligt sind, und die zweite Stufe mit geringerer Temperatur erfolgen. Kondensatoren, die Dielektrika mit mittleren Dielektrizitätszahlen (εᵣ > 1000) haben, werden beispielsweise bei einer Temperatur von 900°C in Stickstoffatmosphäre gebrannt. Kondensatoren aus Materialien mit hohen Dielektrizitätszahlen (εᵣ > 5000) müssen bei einer Temperatur von 1300°C gebrannt werden.

Durch die Verwendung von Keramik als Schaltungsträger wird eine gute Wärmeleitfähigkeit erreicht. Die Spannungsfestigkeit kann durch unterschiedliche Lagendicken oder unterschiedliche Anzahl von Lagen eingestellt werden. Mit Hilfe des erfindungsgemäßen Herstellungsverfahrens können Schaltungsträger auf Keramikbasis mit integrierten resistiven, kapazitiven und/oder induktiven Bauelementen kostengünstig hergestellt werden und durch die Integration kann eine signifikante Miniaturisierung der gesamten Baugruppe erreicht werden.

## Patentansprüche

1. Verfahren zum Herstellen einer elektrischen Baugruppe mit einem Schaltungsträger (100) und einer Vielzahl von in dem Schaltungsträger integrierten passiven Bauelementen, die ein elektrisch funktionales Material aufweisen, wobei mindestens ein passives Bauelement ein Kondensator mit einem Dielektrikum als elektrisch funktionalem Material ist, und wobei das Verfahren die folgenden Schritte umfasst:
Strukturieren des Schaltungsträgers (100), wobei mindestens eine Aussparung (106) für die passiven Bauelementen geschaffen wird,
Einbringen des elektrisch funktionalen Materials (110) in einem Rohzustand in die Aussparung des Schaltungsträgers,
Umwandeln des elektrisch funktionalen Materials aus dem Rohzustand in einen Endzustand mittels mindestens eines Press-Sinter-Schritts,
**dadurch gekennzeichnet,**
**dass** die mindestens eine Aussparung als eine Vielzahl von Vertiefungen ausgebildet ist, wobei die Vertiefungen so ausgeführt sind, dass die passiven Bauelemente unterschiedliche Dicke haben.

2. Verfahren nach Anspruch 1, **dadurch gekennzeichnet, dass** der Schaltungsträger aus einem keramischen Material hergestellt wird.

3. Verfahren nach einem der Ansprüche 1 oder 2, **dadurch gekennzeichnet, dass** mindestens ein passives Bauelement ein Widerstand ist, wobei das elektrisch funktionale Material im Rohzustand eine Paste mit einem bestimmten spezifischen Widerstand ist.

4. Verfahren nach einem der Ansprüche 1 bis 3, **dadurch gekennzeichnet, dass** der Schritt des Einbringens des elektrisch funktionalen Materials im Rohzustand in die Aussparung des Schaltungsträgers das Rakeln einer Paste umfasst.

5. Verfahren nach einem der Ansprüche 1 bis 3, **dadurch gekennzeichnet, dass** der Schritt des Einbringens des elektrisch funktionalen Materials im Rohzustand in die Aussparung des Schaltungsträgers das Einpressen einer Paste umfasst.

6. Verfahren nach einem der Ansprüche 1 bis 5, **dadurch gekennzeichnet, dass** es weiterhin den folgenden Schritt umfasst:
Ausbilden mindestens einer Leiterbahnstruktur zum elektrischen Kontaktieren des elektrisch funktionalen Materials.

7. Verfahren nach einem der Ansprüche 1 bis 6, **dadurch gekennzeichnet, dass** der Schritt des Strukturierens des Schaltungsträgers das Herstellen der Aussparungen durch materialabhebende Bearbeitung umfasst.

8. Verfahren nach einem der Ansprüche 1 bis 7, **dadurch gekennzeichnet, dass** der Schritt des Strukturierens des Schaltungsträgers umfasst:
Ausbilden mindestens einer ersten Schicht,
Ausbilden mindestens einer zweiten Schicht, in der Öffnungen angeordnet sind,
Zusammenfügen der ersten und zweiten Schichten zu dem Schaltungsträger durch Pressen und Brennen der Keramik, so dass durch die Öffnungen die Aussparungen gebildet sind.

9. Verfahren nach Anspruch 8, **dadurch gekennzeichnet, dass** die ersten und zweiten Schichten aus Keramik herstellbar sind und der Schritt des Zusammenfügens das Pressen und Brennen der Keramik umfasst.

10. Verfahren nach Anspruch 8, **dadurch gekennzeichnet, dass** die erste Schicht aus einem elektrisch isolierenden Material herstellbar ist und die zweite Schicht durch eine Metallisierung gebildet ist.

11. Verfahren nach Anspruch 10, **dadurch gekennzeichnet, dass** es weiterhin den folgenden Schritt umfasst:
Entfernen zumindest eines Teils der zweiten Schicht, um die passiven Bauelemente freizulegen.

## Claims

1. Method of manufacturing an electrical unit comprising a circuit carrier (100) and a plurality of passive components which are made from an electrically functional material integrated in the circuit carrier, wherein at least one passive component is a capacitor with a dielectric as the electrically functional material, and wherein the method comprises the following steps:
structuring the circuit carrier (100) by making at least one recess (106) for the passive components,
introducing the electrically functional material (110) in a raw state into the recess of the circuit carrier,
converting the electrically functional material from the raw state into a final state by means of at least one pressing-sintering step,
**characterised in that**
the at least one recess is provided in the form of a plurality of cavities and the cavities are designed so that the passive components are of differing thickness.

2. Method as claimed in claim 1, **characterised in that** the circuit carrier is made from a ceramic material.

3. Method as claimed in one of claims 1 or 2, **characterised in that** at least one passive component is a resistor and, in the raw state, the electrically functional material is a paste with a defined specific resistance.

4. Method as claimed in one of claims 1 to 3, **characterised in that** the step of introducing the electrically functional material in the raw state into the recess of the circuit carrier comprises spreading a paste by means of a blade.

5. Method as claimed in one of claims 1 to 3, **characterised in that** the step of introducing the electrically functional material in the raw state into the recess of the circuit carrier comprises pressing in a paste.

6. Method as claimed in one of claims 1 to 5, **characterised in that** it further comprises the following step:
forming at least one conductor track structure in order to establish an electrical contact with the electrically functional material.

7. Method as claimed in one of claims 1 to 6, **characterised in that** the step of structuring the circuit carrier comprises producing the recesses by machining to remove material.

8. Method as claimed in one of claims 1 to 7, **characterised in that** the step of structuring the circuit carrier comprises:
forming at least a first layer,
forming at least a second layer in which openings are disposed,
joining the first and second layers to obtain the circuit carrier by pressing and firing the ceramic so that the recesses are formed by the openings.

9. Method as claimed in claim 8, **characterised in that** the first and second layers may be produced from ceramic and the joining step comprises pressing and firing the ceramic.

10. Method as claimed in claim 8, **characterised in that** the first layer may be made from an electrically insulating material and the second layer is formed by metallization.

11. Method as claimed in claim 10, **characterised in that** it further comprises the following step:
removing at least a part of the second layer in order to expose the passive components.

## Revendications

1. Procédé de fabrication d'un module électrique avec un support de circuits (100) et une pluralité de composants passifs, intégrés dans le support de circuits et présentant un matériau électriquement fonctionnel, dans lequel au moins un composant passif est un condensateur avec un diélectrique comme matériau électriquement fonctionnel, et dans lequel le procédé comprend les étapes suivantes consistant à :
structurer le support de circuits (100), au moins un évidement (106) étant créé pour les composants passifs,
introduire le matériau (110) électriquement fonctionnel à l'état brut dans l'évidement du support de circuits,
transformer le matériau électriquement fonctionnel de l'état brut à un état final au moyen d'au moins une étape de frittage sous pression,
**caractérisé en ce que** ledit au moins un évidement est réalisé comme une pluralité de creux, les creux étant réalisés de telle sorte que les composants passifs présentent une épaisseur différente.

2. Procédé selon la revendication 1, **caractérisé en ce que** le support de circuits est fabriqué en matériau céramique.

3. Procédé selon l'une quelconque des revendications 1 ou 2, **caractérisé en ce qu'**au moins un composant passif est une résistance, le matériau électriquement fonctionnel à l'état brut étant une pâte ayant une certaine résistance spécifique.

4. Procédé selon l'une quelconque des revendications 1 à 3, **caractérisé en ce que** l'étape consistant à introduire le matériau électriquement fonctionnel à l'état brut dans l'évidement du support de circuits comprend le raclage d'une pâte.

5. Procédé selon l'une quelconque des revendications 1 à 3, **caractérisé en ce que** l'étape consistant à introduire le matériau électriquement fonctionnel à l'état brut dans l'évidement du support de circuits comprend l'injection sous pression d'une pâte.

6. Procédé selon l'une quelconque des revendications 1 à 5, **caractérisé en ce qu'**il comprend en outre l'étape suivante consistant à :
réaliser au moins une structure de pistes conductrices pour établir le contact électrique du matériau électriquement fonctionnel.

7. Procédé selon l'une quelconque des revendications 1 à 6, **caractérisé en ce que** l'étape consistant à structurer le support de circuits comprend la fabrication des évidements par façonnage par enlèvement de matière.

8. Procédé selon l'une quelconque des revendications 1 à 7, **caractérisé en ce que** l'étape consistant à structurer le support de circuits comprend les étapes consistant à :
réaliser au moins une première couche,
réaliser au moins une deuxième couche dans laquelle sont disposées des ouvertures,
assembler les première et deuxième couches pour former le support de circuits par compression et cuisson de la céramique, de sorte que les ouvertures forment les évidements.

9. Procédé selon la revendication 8, **caractérisé en ce que** les première et deuxième couches peuvent être fabriquées en céramique, et l'étape de l'assemblage comprend la compression et la cuisson de la céramique.

10. Procédé selon la revendication 8, **caractérisé en ce que** la première couche peut être fabriquée à partir d'un matériau électriquement isolant, et la deuxième couche est formée par une métallisation.

11. Procédé selon la revendication 10, **caractérisé en ce qu'**il comprend en outre l'étape suivante consistant à :
retirer au moins une partie de la deuxième couche pour exposer les composants passifs.
